# EUROPEAN PATENT APPLICATION

(11) **EP 0 849 600 A1**
(43) Date of publication of application: **24.06.1998**
(21) Application number: 97120970.5
(22) Date of filing: 28.11.1997
(51) Int. Cl.: G01R 15/24

(54) **Optical current transformer**

(30) Priority: 20.12.1996 JP 341375/96
(71) Applicant: MITSUBISHI DENKI KABUSHIKI KAISHA, Tokyo 100 (JP)
(72) Inventor: Yamauchi, Takao, Chiyoda-ku, Tokyo 100 (JP); Ochi, Naoki, Chiyoda-ku, Tokyo 100 (JP)
(74) Representative: Sajda, Wolf E., Dipl.-Phys.

(57) **Abstract**

An optical current transformer is equipped with a current transformer (1) for an air-core instrument for detecting an electric current in a primary conductor (8). The secondary voltage of the coil (3) is applied to a photovoltage sensor (4). A signal processing unit (7) is provided for transmitting a light signal via an optical fiber (5) to the photovoltage sensor (4), and for receiving the light signal passed through the photovoltage sensor (4) via an optical fiber (6), and outputting a current detection signal.

## Description

### BACKGROUND OF THE INVENTION

The present invention relates to a current transformer for an optical instrument applicable to gas-insulated switchgears which are used for transmission and distribution, reception and transformation of electric power.

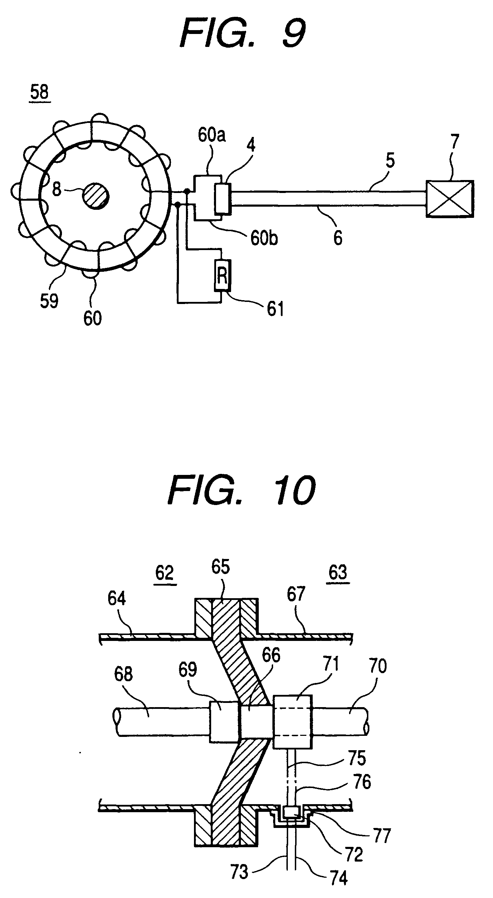

Fig. 10 shows one known current transformer for an optical instrument as disclosed in Japanese Patent Publication 4-127068. In Fig. 10, reference numeral 62 denotes a gas-insulated switchgear; 63, a current transformer for an optical instrument; 64, a container; 65, an insulating spacer; 66, a conductor; 67, a container; 68, a conductor; 69, a shielded conductor; 70, a conductor; 71, a photocurrent sensor; 72, a light emitting-receiving unit; 73-74, optical fibers; 75-76, light paths; and 77, a terminal cover.

In Fig. 10, the photocurrent sensor 71 is installed around the conductor 70 so that a magnetic field proportional to an electric current flowing into the conductor 70 is applied to the photocurrent sensor 71. When light flows into the conductor 70 after passing through the optical fiber 73, the light emitting-receiving unit 72, the light path 75, the photocurrent sensor 71, the light path 76, the light emitting-receiving unit 72 and the optical fiber 74, a light signal proportional to the magnetic field, that is, current in the conductor 70 is obtainable because of the Faraday effect of the photocurrent sensor 71. The current transformer for an optical instrument is constituted of the aforementioned parts and a signal processing unit for processing the light signal.

Such a current transformer for an optical instrument is advantageous in that it is small-sized without being affected by electromagnetic noise since a signal is transmitted through optical fibers. As shown in Fig. 10, however, it is needed to fit the axis of the light path 75 precisely to that of the light path 76 and this makes greater the size of the photocurrent sensor 71 made of lead glass, thus rendering it expensive.

Since the conventional current transformer for an optical instrument is thus organized, the axial precision of the light path is easily affected by the vibration of the equipment and the shortcoming is that a detection error is caused thereby or if the photocurrent sensor is increased in size to prevent the error, the current transformer tends to become costly.

Moreover, detection characteristics are easily affected by fitting precision and the like because the magnetic field applied to the photocurrent sensor is determined by the positional relation between the photocurrent sensor and the conductor.

### SUMMARY OF THE INVENTION

An object of the present invention intended to solve the forgoing problems is to provide a current transformer for an optical instrument which is free from the effect of vibration and economical.

An optical current transformer according to the present invention is provided with a current transformer for detecting an electric current flowing into a conductor by electromagnetic induction, and voltage-to-light conversion means for converting the secondary voltage of the current transformer into a light signal so as to output a current detection signal.

An optical current transformer according to the present invention is such that the voltage-to-light conversion means includes a photovoltage sensor as an electro-optical element to which the secondary voltage of the current transformer is applied, and a signal processing unit for transmitting a light signal via an optical fiber to the photovoltage sensor, receiving the light signal passed through the photovoltage sensor via an optical fiber so as to output a current detection signal.

According to the present invention, the current transformer may be a current transformer for an air-core instrument without the use of an iron core.

According to the present invention, the current transformer may be a current transformer for an iron-core instrument with the use of an iron core.

In the optical current transformer according to the present invention, a resistor is connected in parallel to the photovoltage sensor on the secondary side of the current transformer so as to prevent the generation of overvoltage when the secondary side is opened.

In the optical current transformer, a terminal box for accommodating a terminal for use in leading out the secondary voltage of the current transformer is provided; and the photovoltage sensor is disposed in the terminal box.

In the optical current transformer, the current transformer is disposed in a container for enclosing an insulating gas for a gas-insulated switchgear; a terminal box for accommodating a terminal for use in letting the secondary voltage of the current transformer airtightly pass through the container and leading out the secondary voltage thereof into an atmosphere is provided; and the photovoltage sensor is disposed in the terminal box.

In the optical current transformer, a current transformer equivalent to three phases is disposed in a container for enclosing an insulating gas for a three-phase collective type gas-insulated switchgear; a terminal box for accommodating a terminal for use in letting the secondary voltage of the current transformer equivalent to three phases collectively and airtightly pass through the container from one place of the container and leading out the secondary voltage thereof into a gaseous atmosphere is provided; and the photovoltage sensor equivalent to three phases is disposed in the terminal box.

Furthermore, in optical current transformer, the photovoltage sensor is fixedly mounted on the current transformer so that the photovoltage sensor is integral with the current transformer.

Furthermore, in optical current transformer, a hollow insulating support material is used for supporting the current transformer and the photovoltage sensor which are disposed in the high-tension potential portion of a conductor; the signal processing unit is disposed in a ground potential portion; and the optical fibers installed within the insulating support material are used for connecting the photovoltage sensor and the signal processing unit.

Still further, in optical current transformer, an impedance is connected in parallel to the photovoltage sensor on the secondary side of the current transformer so that the high-frequency component applied to the photovoltage sensor is suppressed.

Still further, in optical current transformer, a plurality of photovoltage sensors are connected in parallel to the secondary side of a single current transformer so that the photovoltage sensors, and the optical fibers as well as the signal processing unit at the following stage of the photovoltage sensor are double-structured.

### BRIEF DESCRIPTION OF THE DRAWINGS

Figure 1 is a diagram illustrating the construction and operation of a current transformer for an optical instrument according to first embodiment of the present invention;
Figure 2 is a diagram illustrating a current transformer for an optical instrument according to second embodiment of the present invention;
Figure 3 is a diagram illustrating a current transformer for an optical instrument according to third embodiment of the present invention;
Figure 4 is a diagram illustrating a current transformer for an optical instrument according to fourth embodiment of the present invention;
Figure 5 is a detailed diagram illustrating the mount of the photovoltage sensor in Fig. 4;
Figure 6 is a diagram illustrating a current transformer for an optical instrument according to fifth embodiment of the present invention;
Figure 7 is a diagram illustrating a current transformer for an optical instrument according to sixth embodiment of the present invention;
Figure 8 is a diagram illustrating a current transformer for an optical instrument according to seventh embodiment of the present invention;
Figure 9 is a diagram illustrating a current transformer for an optical instrument according ton eighth embodiment of the present invention; and
Figure 10 is a diagram illustrating a conventional current transformer for an optical instrument.

### DETAILED DESCRIPTION OF THE PREFERRED EMBODIMENTS

### Embodiment 1

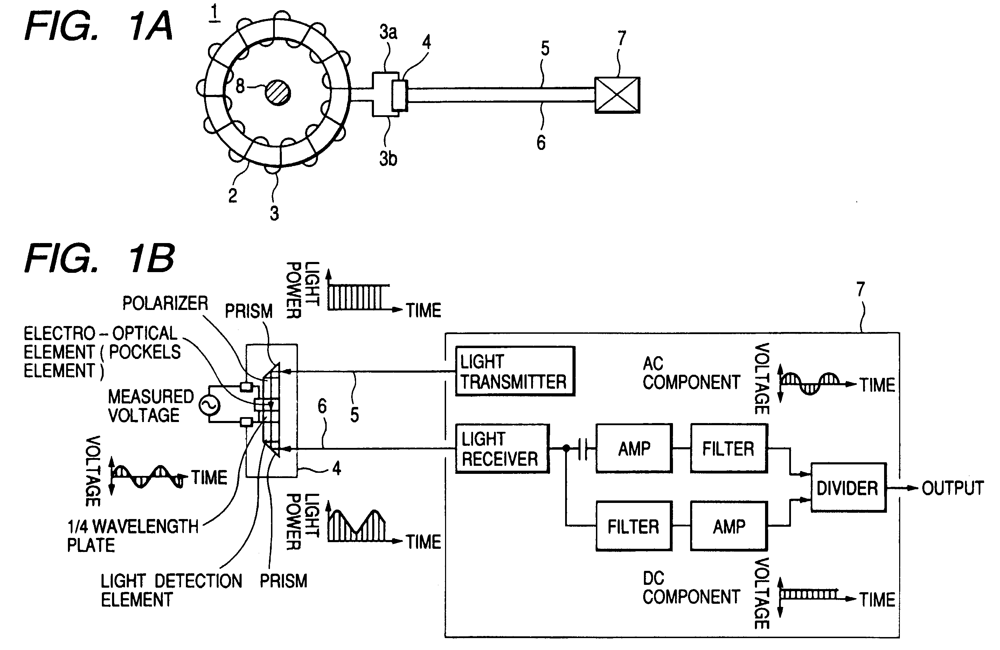

An embodiment of the present invention will now be described with reference to the accompanying drawings. Fig. 1 is intended to explain the principle of a current transformer for an optical instrument according to the present invention. Fig. 1A is a basic block diagram; and Fig. 1B a diagram illustrating the operation thereof. In Fig. 1A, reference numeral 1 designates a current transformer for an air-core instrument; 2, an annular frame made of nonmagnetic or inorganic material; 3, a (secondary) coil uniformly wound on the annular frame 2; 3a and 3b, terminal lines of the coil; 4, a photovoltage sensor; 5 and 6, optical fibers; 7, a signal processing unit; and 8, a primary conductor.

The operation will subsequently be described. A secondary voltage signal proportional to current flowing in the primary conductor 8 is generated between the terminal lines 3a, 3b of the current transformer 1 for an air-core instrument and applied to the photovoltage sensor 4. A light signal having constant power is introduced from the light transmitter of the signal processing unit 7 via the optical fiber 5 into the photovoltage sensor 4 and returned via the optical fiber 6 to the light receiver of the signal processing unit 7. In the photovoltage sensor 4 during this process, due to the Pockels effect by which the refractive index of light in the direction of its polarization varies in proportion to the voltage applied to an electro-optical element (Pockels element) in the photovoltage sensor, that is, the electric field, there exists the light signal modulated by the secondary voltage signal. As shown in Fig. 1B, the photovoltage sensor 4 is constituted of a prism, a polarizer, the electro-optical element (Pockels element), a 1/4 wavelength plate, a light detection element, a prism and so forth, the photovoltage sensor together with the signal processing unit having the function of converting the voltage signal to the light signal via the optical fibers.

An output from the light receiver within the signal processing unit 7 is divided into an AC and a DC component, each of which is subjected to waveform shaping, and synthesized before being output via an operator for calculating a ratio to an input signal.

The current transformer for an optical instrument as shown in Fig. 1A is hardly affected by an external magnetic field and as it is a current transformer for an air-core instrument without an iron core, which results in making the apparatus free from saturation characteristics, conversion to the light signal via the optical fibers is effected by applying the secondary voltage signal proportional to a primary current as an object of detection in order to transmit the light signal to the signal processing unit. Therefore, the current transformer for an air-core instrument, the photovoltage sensor, the optical fibers, the signal processing unit and so forth as the component parts remain unaffected by electromagnetic noise and are small-sized, excellent in vibration resistance and economical.

The current transformer 1 for an air-core instrument is designed to detect current in the primary conductor 8 from the voltage induced in the coil according to the principle of so-called electromagnetic induction and it never occurs that positional relation to the primary conductor 8 delicately affects the detection characteristics.

### Embodiment 2

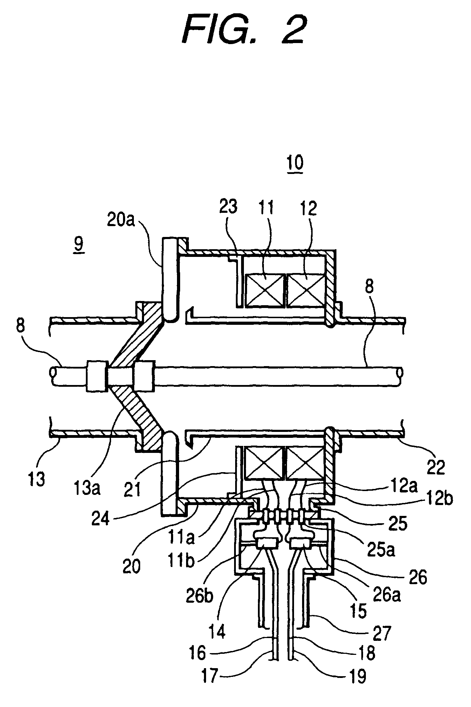

A description will subsequently be given of Embodiment 2 of the present invention. In Fig. 2, reference numeral 9 designates a gas-insulated switchgear; 10, a current transformer unit for an optical instrument; 11 and 12, current transformers for an air-core instrument; 11a, 11b, 12a and 12b, terminal lines from the respective current transformers 11, 12 for an air-core instrument; 13, a container for enclosing an insulating gas; 13a, an insulating spacer; 14 and 15, photovoltage sensors; 16, 17, 18 and 19, optical fibers whose lower ends are connected to a signal processing unit (not shown); 20, a container; 20a, a flange; 21, a shield for the current transformers; 22, a container; and 23 and 24, metal parts for fixing the current transformers for an air-core instrument.

Further, numeral 25 designates a hermetically sealed terminal plate for leading out the terminal lines 11a, 12a and the like airtightly from the current transformers 11, 12 for an air-core instrument contained in the container 20 into an gaseous atmosphere; 25a, metal parts of the hermetically sealed terminal plate 25; 26 a terminal box for accommodating the hermetically sealed terminal plate 25 and the terminal metal parts 25a; 26a and 26b, photovoltage-sensor fitting metal parts; and 27, a protective tube. Fig. 2 refers to a case where the two current transformers 11, 12 for an air-core instrument are arranged in the insulating gas of the gas-insulated switchgear and the two photovoltage sensors are accommodated in the terminal box of the current transformer unit, whereby great reliability is obtainable from this complete double structure. The signal processing unit is separately placed in a low-electromagnetic- noise position.

Since the current transformers 11, 12 for an air-core instrument of the current transformer for an optical instrument are disposed in the container 20 of the gas-insulated switchgear, the current transformers remain unaffected by current flowing into the container and also far less unaffected by the external magnetic field. Moreover, the terminal lines of the current transformers for an air-core instrument are connected via the metal parts of the hermetically sealed terminal plate 25 to the photovoltage sensors 14, 15 disposed inside the terminal box 26 in the gas and consequently the length of lines from the current transformers for an air-core instrument up to the photovoltage sensors is shortened. Therefore, the influence of electromagnetic noise is reduced and the photovoltage sensors are readily inspected as they are inside the terminal box in the gas. Further, since it is unnecessary for the optical fibers to be passed through the airtight containers, an additional advantage is that reliability of preventing gas leakage is improved, for example.

Although Fig. 2 refers to the case where the present invention is applied to the use of the two current transformers for an optical instrument, the invention is applicable to three devices or greater likewise.

### Embodiment 3

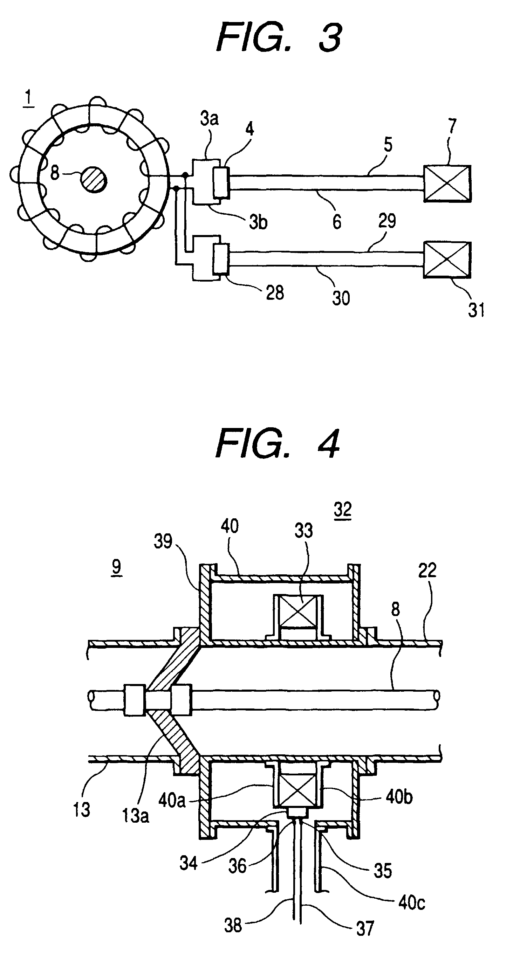

A description will subsequently be given of Embodiment 3 of the present invention, wherein a portion at the following stage of a current transformer 1 for an air-core instrument is double-structured. In Fig. 3, reference numeral 28 designates a photovoltage sensor; 29 and 30, optical fibers; and 31, a signal processing unit. As the impedance of the photovoltage sensors 4, 28 is high, the detecting operation is made performable without trouble even by connecting these photovoltage sensors to the secondary side of the current transformer for an air-core instrument in parallel. Thus, the secondary side of the current transformer for an air-core instrument can simply be structured double and reliability is economically improvable in comparison with the preceding Embodiment 2 of the present invention. Needless to say, this embodiment of the present invention is also applicable to three devices in the same system as described above.

### Embodiment 4

A description will subsequently be given of Embodiment 4 of the present invention, wherein a current transformer for an optical instrument is disposed outside the container of a gas-insulated switchgear. In Fig. 4, reference numeral 32 designates a current transformer unit for an optical instrument; 33, a current transformer for an air-core instrument; 34, a photovoltage sensor integrally fixed to the current transformer 33 for an air-core instrument as will be described later; 35 and 36, optical connectors; 37 and 38, optical fibers; 39, a flange; 40, a current transformer cover; 40a and 40b, fitting metal parts; and 40c, a protective tube.

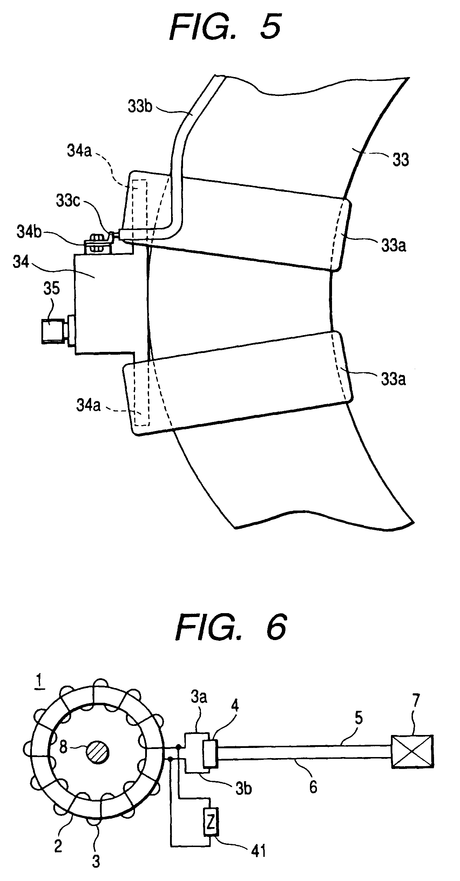

Fig. 5 shows a portion of integral structure in detail resulting from mounting the photovoltage sensor 34 on the current transformer 33 for an air-core instrument. Further, numeral 33b designates a lead wire on one side of the secondary coil of the current transformer 33 for an air-core instrument with a terminal 33c connected to the fore-end of the lead wire; 34a, legs for use in mounting the photovoltage sensor 34, which is made integral with the current transformer 33 for an air-core instrument by winding insulating tapes thereon; and 34b a voltage applying terminal for use in applying voltage to the photovoltage sensor 34, a terminal 33c being connected to the voltage applying terminal with a locking bolt. In this case, when a fixing metal part is fitted to the side of the current transformer for an air-core instrument beforehand, the metal part may be used to mount the photovoltage sensor on the current transformer for an air-core instrument with a clamping bolt. The current transformer for an air-core instrument and the photovoltage sensor may otherwise be combined integrally by molding.

As described above, the photovoltage sensor 34 and the optical connectors 35, 36 are formed integrally with the current transformer 33 for an air-core instrument and when the current transformer 33 for an air-core instrument is handled, it is easy to handle because no optical fibers are employed. Further, testing and the like can be made by connecting the optical connectors and the optical fibers, so that these operations are performable with efficiency. Since the structure of the terminal box is simple, that of the current transformer is economical.

### Embodiment 5

A description will subsequently be given of Embodiment 5 of the present invention. In Fig. 6, reference numeral 41 designates an impedance of a zinc oxide element, a capacitor, a resistor, reactor or a combination of these, the photovoltage sensor 4 being connected to the current transformer 1 for an air-core instrument in parallel. When a high-frequency surge current flows into the primary conductor 8, a high-tension surge may be induced in the coil of the current transformer 1 for an air-core instrument, which is suppressed by the aforementioned impedance 41 in order to protect a photovoltage sensor 4.

### Embodiment 6

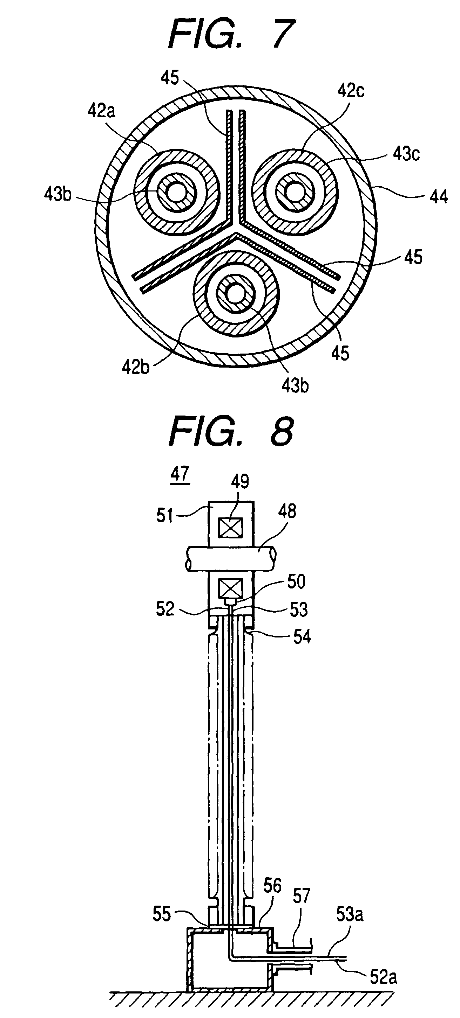

A description will subsequently be given of Embodiment 6 of the present invention, wherein a current transformer for an optical instrument is applied to a three-phase collective type gas-insulated switchgear. In Fig. 7, reference numerals 42a, 42b and 42c designate a current transformer for an air-core instrument equivalent to three phases; 43a, 43b and 43c, a primary conductor equivalent to three phases; 44, a container; and 45, a electromagnetic shielding plate for preventing layer-to-layer mutual induction. The collective provision of one terminal box for the container 44 of Fig. 7 and a photovoltage sensor equivalent to three phases as shown in Fig. 2 results in decreasing the dimensions, thus facilitating the arrangement of optical fibers economically.

### Embodiment 7

A description will subsequently be given of Embodiment 7 of the present invention, wherein a current transformer for an optical instrument is placed in a gaseous atmosphere. In Fig. 8, reference numeral 47 designates a current transformer for an optical instrument; 48, a high-tension conductor; 49, a current transformer for an air-core instrument; and 50, a photovoltage sensor, these current transformer 49 for an air-core instrument and the photovoltage sensor 50 being molded into one body with an insulating material 51. Further, numerals 52, 52a, 53, 53a designate optical fibers used to connect the photovoltage sensor 50 and a signal processing unit (not shown) placed in a large ground potential portion; 54, an insulating support material; 55, a bottom cover for the support insulating material 54; 56, a current transformer box; and 57, a protective tube.

In this Embodiment 7 of the present invention, though the photovoltage sensors 52, 53 from the photovoltage sensor 50 are disposed in the hollow insulating support material 54, the inner diameter of the hollow insulating support material 54 can be small as the photovoltage sensors are thin. Since the current transformer 49 for an air-core instrument is small-sized and lightweight, this makes reducible the dimensions of the insulating support material 54 and consequently makes the insulating support material economical. The insulating support material 54 may be made of ceramics or organic material and commonly used for a breaker, a disconnecting switch or a bus support other than the current transformer.

### Embodiment 8

A description will subsequently be given of Embodiment 8. In Fig. 9, reference numeral 58 designates a current transformer for an iron-core instrument; 59, an annular iron core; 60, a (secondary) coil uniformly wound on the iron core 59; 60a and 60b, terminal lines; and 61, a resistor. Although there have been shown the combination of the current transformer for an air-core instrument and the photovoltage sensor up to Embodiment 7 of the present invention, Fig. 9 refers to a case where a current transformer for an iron-core instrument instead of the current transformer for an air-core instrument is combined with a resistor. Due to the combination of the current transformer for an iron-core instrument and the resistor, the sectional area of the coil is reducible enough to economize the current transformer and make it fit for practical use. The resistor 61 is required to prevent abnormal voltage from being generated because the secondary side of the current transformer is left open, though a small resistance value can be satisfactory, and it is reasonable to fit the terminal box with the resistor as shown in Fig. 2. The application of this current transformer for an optical instrument is similar to that of any conventional one.

The arrangement that has been made in each embodiment of the present invention is to provide the photovoltage sensor and the signal processing unit separately from each other with the optical fibers used to connect them; however, both of them may be connected via light paths without using optical fibers or otherwise combined integrally in that the light emitter and light receiver of the signal processing unit and the photovoltage sensor are directly coupled together. The point is an optical current transformer capable of stably obtaining detection characteristics without being influenced by the conditions of installation is attainable as long as the current detection signal is made obtainable through the secondary-voltage-to-light conversion by the use of the current transformer of such a type as to detect current by electromagnetic induction.

With respect to the current transformer, use may be made of various types of current transformers such as those using an iron core with a space gap or any of the various magnetic materials for the purpose of detecting an electric current in a conductor from the voltage induced in the secondary coil by electromagnetic induction.

As set forth above, since the optical current transformer according to the present invention is equipped with a current transformer for detecting an electric current flowing into a conductor by electromagnetic induction, and voltage-to-light conversion means for converting the secondary voltage of the current transformer into a light signal so as to output a current detection signal, a current detection signal via a light signal is precisely and stably obtainable according to detection characteristics without being affected by precision in the installation of equipment.

Since the voltage-to-light conversion means of the optical current transformer according to the present invention includes a photovoltage sensor as an electro-optical element to which the secondary voltage of the current transformer is applied, and a signal processing unit for transmitting a light signal via an optical fiber to the photovoltage sensor, receiving the light signal passed through the photovoltage sensor via an optical fiber so as to output a current detection signal, an optical current transformer obtainable is economical, excellent in vibration resistance and has great freedom of component arrangement and the like.

Since a current transformer for an air-core instrument without the use of an iron core is employed as the current transformer of the optical current transformer according to the present invention, a current transformer for an optical instrument obtainable is lightweight and offers high precision without saturation characteristics.

Since a current transformer for an air-core instrument with the use of an iron core is employed as the current transformer of the optical current transformer according to the present invention, a current transformer for an optical instrument obtainable is small-sized and less costly.

Since the optical current transformer according to the present invention is such that a resistor is connected in parallel to the photovoltage sensor on the secondary side of the current transformer so as to prevent the generation of overvoltage when the secondary side is opened, an optical current transformer obtainable is highly reliable to ensure that the photovoltage sensor is protected from overvoltage.

Since the optical current transformer according to the present invention is such that a terminal box for accommodating a terminal for use in leading out the secondary voltage of the current transformer is provided; and the photovoltage sensor is disposed in the terminal box, the optical current transformer is easy to handle.

Since the optical current transformer according to the present invention is such that the current transformer is disposed in a container for enclosing an insulating gas for a gas-insulated switchgear; a terminal box for accommodating a terminal for use in letting the secondary voltage of the current transformer airtightly pass through the container and leading out the secondary voltage thereof into a gaseous atmosphere is provided; and the photovoltage sensor is disposed in the terminal box, an optical current transformer obtainable is less affected by electromagnetic noise as the total length of a connection line between the current transformer and the photovoltage sensor, and easy to handle and inspect.

Since the optical current transformer according to the present invention is such that a current transformer equivalent to three phases is disposed in a container for enclosing an insulating gas for a three-phase collective type gas-insulated switchgear; a terminal box for accommodating a terminal for use in letting the secondary voltage of the current transformer equivalent to three phases collectively and airtightly pass through the container from one place of the container and leading out the secondary voltage thereof into a gaseous atmosphere is provided; and the photovoltage sensor equivalent to three phases is disposed in the terminal box, an optical current transformer obtainable becomes compact as what is used for the detection of a three-phase current.

Since the optical current transformer according to the present invention is such that the photovoltage sensor is fixedly mounted on the current transformer so that the photovoltage sensor is integral with the current transformer, the total length of a connection line between the current transformer and the photovoltage sensor is shortened further and the optical current transformer is made more compact.

Since the optical current transformer according to the present invention is such that a hollow insulating support material is used for supporting the current transformer and the photovoltage sensor which are disposed in the high-tension potential portion of a conductor; the signal processing unit is disposed in a ground potential portion; and the optical fibers installed within the insulating support material are used for connecting the photovoltage sensor and the signal processing unit, the detection of current in the gas-insulated high-tension conductor can be made simply and economically with a simple structure.

Since the optical current transformer according to the present invention is such that an impedance is connected in parallel to the photovoltage sensor on the secondary side of the current transformer so that the high-frequency component applied to the photovoltage sensor is suppressed, an optical current transformer obtainable is highly reliable to ensure that the photovoltage sensor is protected from a high-tension surge.

Since the optical current transformer according to the present invention is such that a plurality of photovoltage sensors are connected in parallel to the secondary side of a single current transformer so that the photovoltage sensors, and the optical fibers as well as the signal processing unit at the following stage of the photovoltage sensor are double-structured, the detection system can simply be multiplex-structured and reliability is made improvable at low cost.

While various features and advantages of the invention have been described in connection with several embodiments of the invention, it should be clear that the various features and embodiments can readily be combined with each other resulting in further embodiments which are well within the scope of the present invention.

## Claims

1. An optical current transformer comprising:
a current transformer (1, 11, 12) for detecting an electric current flowing in a conductor by electromagnetic induction; and
voltage-to-light conversion means (4, 14, 15) for converting the secondary voltage of the current transformer into a light signal so as to output a current detection signal.

2. An optical current transformer as claimed in claim 1, wherein the voltage-to-light conversion means includes:
a photovoltage sensor (4, 14, 15) as an electro-optical element to which the secondary voltage of the current transformer (1) is applied; and
a signal processing unit (7) for transmitting a light signal via an optical fiber (5) to the photovoltage sensor (4, 14, 15), receiving the light signal passed through the photovoltage sensor (4, 14, 15) via another optical fiber (6) so as to output a current detection signal.

3. The transformer as claimed in claim 2,
wherein the current transformer (1, 11, 12) is for an air-core instrument without the use of an iron core.

4. The transformer as claimed in claim 2,
wherein the current transformer (1, 11, 12) is for an iron-core instrument with the use of an iron core.

5. The transformer as claimed in any of claims 2 to 4,
wherein a resistor (61) is connected in parallel to the photovoltage sensor (4) on the secondary side of the current transformer (1) so as to prevent the generation of overvoltage when the secondary side is opened.

6. The transformer as claimed in any of claims 2 to 4,
wherein an impedance (41) is connected in parallel to the photovoltage sensor (4) on the secondary side of the current transformer (1) so that the high-frequency component applied to the photovoltage sensor is suppressed.

7. The transformer as claimed in any of claims 2 to 6,
wherein a plurality of photovoltage sensors (4, 28) are connected in parallel to the secondary side of a single current transformer (1) so that the photovoltage sensors (4, 28) and the optical fibers as well as the signal processing unit (7, 31) at the following stage of the photovoltage sensor (4, 28) are double-structured.

8. The transformer as claimed in any of claims 2 to 7, further comprising:
a terminal box (26) for accommodating a terminal (25) for use in leading out the secondary voltage of the current transformer (11, 12), wherein the photovoltage sensor (14, 15) is disposed in the terminal box (26).

9. The transformer as claimed in any of claims 2 to 7,
wherein the current transformer (11, 12) is disposed in a container (13) for enclosing an insulating gas for a gas-insulated switchgear;
wherein a terminal box (26) for accommodating a terminal (25) for use in letting the secondary voltage of the current transformer airtightly pass through the container (13) and leading out the secondary voltage thereof into a gaseous atmosphere is provided;
and wherein the photovoltage sensor (14, 15) is disposed in the terminal box (26).

10. The transformer as claimed in any of claims 2 to 7,
wherein the current transformer (42a, 42b, 42c) equivalent to three phases is disposed in a container (44) for enclosing an insulating gas for a three-phase collective type gas-insulated switchgear;
wherein a terminal box (26) for accommodating a terminal for use in letting the secondary voltage of the current transformer (42a, 42b, 42c) equivalent to three phases collectively and airtightly pass through the container from one place of the container and leading out the secondary voltage thereof into a gaseous atmosphere is provided; and wherein the photovoltage sensor equivalent to three phases is disposed in the terminal box (26).

11. The transformer as claimed in any of claims 2 to 10,
wherein the photovoltage sensor (34) is fixedly mounted on the current transformer (33) so that the photovoltage sensor is integral with the current transformer.

12. The transformer as claimed in any of claims 2 to 11,
wherein a hollow insulating support material (51) is used for supporting the current transformer (47) and the photovoltage sensor which are disposed in the high-tension potential portion of a conductor (48);
wherein the signal processing unit (7) is disposed in a ground potential portion;
and wherein the optical fibers (52a, 53a) installed within the insulating support material (51) are used for connecting the photovoltage sensor and the signal processing unit.
